# EUROPEAN PATENT APPLICATION

(11) **EP 1 739 685 A1**
(43) Date of publication of application: **03.01.2007**
(21) Application number: 06253392.2
(22) Date of filing: 29.06.2006
(51) Int. Cl.: G21C 19/307, C23F 11/18, C23C 30/00, F04F 5/10

(54) **Method for mitigating oxide fouling on structural components in light water reactors**

(30) Priority: 30.06.2005 US 169689
(71) Applicant: The General Electric Company, Schenectady NY 12345 (US)
(72) Inventor: Dulka, Catherine Procik, West Chester, Pennsylvania 19380 (US); Sandusky, David, Los Gatos, California 95030 (US); Kim, Young Jin, Clifton Park, New York 12065 (US)
(74) Representative: Pedder, James Cuthbert

(57) **Abstract**

To minimize, reduce or eliminate electrostatic deposition of charged particulates carried by coolant on component wall surfaces in the water circulation system of a nuclear reactor, the component surfaces are coated with one of a noble metal or a noble metal alloy. The resulting sign of the component surface is of like sign as the charged particulates in the coolant flow.

## Description

The present invention relates to a method for mitigating, minimizing or eliminating deposition of metal or metal oxide particles on various components in high temperature/flow water, by applying one or more noble metals to the surface, such that the suspended particles and the component surface interact to preclude or minimize fouling of the component surface.

Typically, during the operation of boiling water nuclear reactors (BWRs) under normal water chemistry conditions containing high oxidizing species, such as oxygen and hydrogen peroxide, inter-granular stress corrosion cracking (IGSCC) of reactor components e.g. sensitized 304 stainless steel, is known to be a major environment-related material performance concern. It has also been observed that a thick, dense layer of crud, (mostly metal oxides) is deposited on components exposed to high temperature/high flow water, such as a jet pump inlet mixer assembly for the BWR. This crud buildup substantially reduces water velocities, results in reduction in core flow capability, and thus, at refueling outages, the crud deposited surfaces typically need to be cleaned.

Particularly, and as a representative example, a recirculation pump in a BWR causes a downward flow of coolant in the annular space between the core shroud and the reactor pressure vessel wall. The coolant is pumped to a high pressure, and distributed through a manifold to the jet pumps, where the coolant flows in a upward direction through the jet pump risers. The coolant then splits in a transition piece, changes direction, and is accelerated downwardly through the nozzles and into a mixer section of the jet pump. The nozzles cause a high velocity coolant flow that is approximately one third of the core flow and discharges into the throat section of the inlet-mixers.

Over time, an oxide layer builds-up on the inside of the inlet-mixers including the jet pump nozzles, forming a layer of crud. There is also the potential of stress corrosion cracking along these surfaces. The build―up of crud is believed to be caused by electrically charged metallic/metal oxide particles suspended in the coolant which interact with the metallic inner surface of the inlet-mixer, including a triboelectrostatic charge on the surface. This charge creates an electrostatic potential that attracts the suspended particles in the coolant to the metallic surface where they form a layer. The highest deposition of crud is observed in areas that experience the highest flow rates.

As the crud layer becomes excessive, the performance of the recirculation system will be degraded. This degradation will also adversely affect the efficiency of the plant because the recirculation pumps must be run at a higher speed to maintain core flow. Degradation of jet pump performance can further result in extreme vibration and damage to jet pump components. Eventually, the inlet-mixer must be mechanically or chemically cleaned or replaced during regular maintenance and refueling outages, which is costly and time consuming.

Consequently, it is important that the crud layer be eliminated, substantially minimized or its rate of build-up curtailed. One such method for accomplishing that objective is disclosed in U.S. Patent No. 6,633,623 issued October 14, 2003 of common assignee herewith. Under normal water chemistry conditions, and according to that patent, the fouling of metal oxides on component surfaces can be reduced by applying a ceramic coating to the surfaces. For example, a coating formed of TiO₂ or Ta₂O₅, Si02 or yttria stabilized zirconia may be applied to the surfaces. That dielectric coating reduces the electrical potential between the metal of the component surfaces e.g., an inlet mixer and the charged metallic particles in the water minimizing or eliminating the build-up of crud on the surfaces of the inlet mixer. While that dielectric coating has been demonstrated to satisfactorily reduce the deposition of crud on the component surfaces, it has been found less effective for use on component surfaces in hydrogenated water. Accordingly, there is a need to provide apparatus and methods to mitigate, reduce or eliminate the deposition of metal or metal oxide particles in high temperature/flow water on component surfaces in hydrogen water chemistry (HWC). The present invention seeks to provide a solution to this problem.

In a preferred embodiment of the present invention, there is provided a method of reducing, minimizing or eliminating deposition of charged particulates on metal surfaces of a component subject to high temperature/high flow water, the method comprising the step of applying at least one noble metal or an alloy thereof to the surface.

In a further preferred embodiment of the present invention, there is provided a method of reducing, minimizing or eliminating deposition of charge particulates on interior metal wall surfaces defining a coolant flow passage in a jet pump for a nuclear reactor comprising the step of: depositing one of a noble metal or noble metal alloy on the interior metal wall surfaces of one of a nozzle and a mixing section forming part of an inlet mixer of the jet pump for disposition in the radioactive environment of the nuclear reactor to reduce, minimize or eliminate an electric potential between the metal wall surfaces and the charged particulates.

In another embodiment of the invention, there is provided a method for protecting interior metal wall surfaces defining a coolant water flow passage in a jet pump for a nuclear reactor comprising steps of reducing, minimizing or eliminating deposition of charged particulates in the coolant water flowing through the jet pump on the metal wall surfaces by depositing a noble metal or a noble metal alloy on the interior metal wall surfaces of one of a nozzle and a mixing section forming part of an inlet mixer of the jet pump, thereby to reduce, minimize or eliminate any electric potential between the metal wall surfaces and the charged particulates.

The invention will now be described in greater detail, by way of example, with reference to the drawings, in which:-
FIG. 1 is a fragmentary perspective view with portions broken out of a jet pump in an annular space between the inner shroud and the pressure vessel wall of a nuclear reactor;
FIG. 2 is an enlarged elevational view of a transition piece adjacent the top of the pump, an inlet-mixer, and a diffuser, with parts in cross-section for ease of illustration; and
FIG. 3 is an enlarged fragmentary cross-sectional view of a nozzle discharge port of the inlet-mixer.

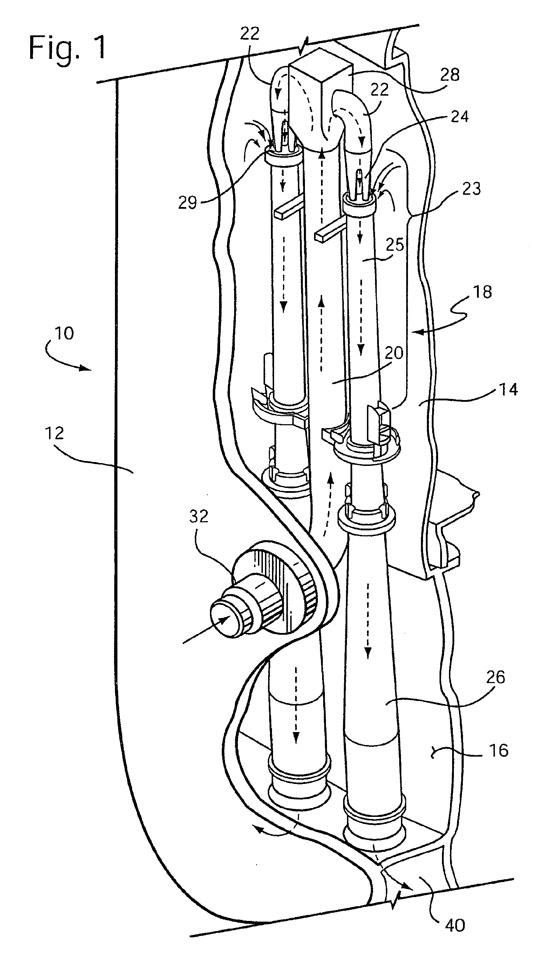

Referring now to the drawings, particularly to FIG. 1, there is illustrated a nuclear reactor pressure vessel, generally designated 10, having a reactor pressure vessel wall 12 and an inner core shroud 14 defining a generally annular space 16 therebetween. The annular space 16 contains coolant. As in a typical boiling water nuclear reactor, a plurality of jet pumps, one being generally designated 18, are disposed at circumferential spaced positions about the pressure vessel between the pressure vessel wall 12 and the core shroud 14 and in the annular space 16. Each jet pump 18 typically comprises an inlet riser 20, a transition piece 28 adjacent the upper end of the inlet riser 20, a pair of elbows 22, inlet-mixers 23, each including nozzles 24 and mixing sections 25, and diffusers 26. Hold-down assemblies adjacent the top of the jet pump 18, together with a number of braces and restraints maintain each jet pump 18 in fixed position in the annular space 16 between the core shroud 14 and pressure vessel wall 12. A thermal sleeve 32 penetrates the pressure vessel wall 12 and is welded at its juncture with an inlet elbow. The opposite end of the inlet elbow is secured to the lower end of the inlet riser 20. It will be appreciated that the foregoing-described jet pump 18 is conventional in construction. Thus, coolant enters the thermal sleeve 32 and flows through the elbow, upwardly in the inlet riser 20, through the inlet elbows 22 through nozzles 24 for flow in a downward direction through the mixing sections 25, the diffusers 26 and into a plenum 40 for upward flow through the reactor core. As conventional, the jet pump nozzles 24 induce a suction flow of coolant from the annular space 16 into the mixing section 25 which mixes with the coolant flow through the jet pump nozzles 23.

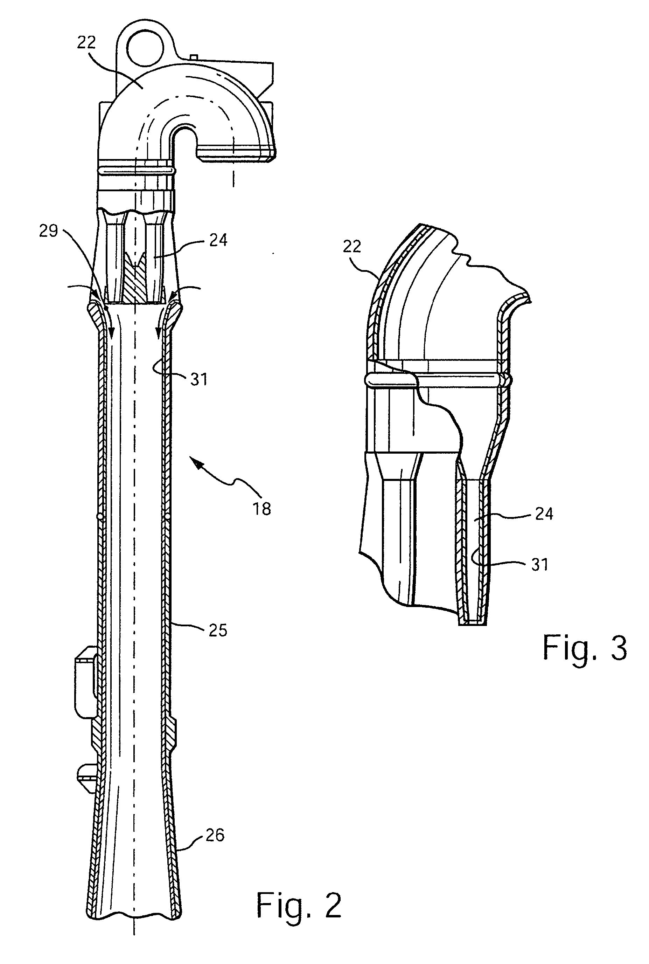

Referring more particularly to FIG. 2, there is illustrated a portion of a jet pump 18 having an inlet elbow 22 adjacent five nozzles 24. The nozzles 24 are supported above the mixing sections 25 and define therewith a generally annular suction flow passage 29 between the nozzles 24 and an inlet to the mixing section 25. It will be appreciated that the mixing section 25 is a cylindrical pipe which terminates at its lower end in an inlet to the diffuser 26. Consequently, the flow of coolant through the nozzles 24 induces a suction flow of coolant through the annular spacer 16 for flow into the mixing section 25. These combined nozzle and suction flows pass through the mixing section 25 and diffuser 26 and into plenum 40.

Referring now to FIG. 3, there is illustrated two of the nozzles 24. It will be appreciated that the interior passages through nozzles 24 are conical in shape with the diameter decreasing along the path of the fluid flow, thereby increasing the flow velocity into mixing section 25. The increased velocity induces additional fluid to flow into the sleeve through the annular opening 29 between the nozzles 23 and the mixer sleeve inlet as indicated by the arrows in FIG. 2.

In accordance with a preferred embodiment of the present invention, the inlet-mixer 23 is provided with a coating that inhibits or eliminates "crud" build-up. To accomplish this, one of the noble metals is applied to the component surface e.g., the surfaces of the inlet/mixer 23. Platinum is a preferred noble metal for use in this application, although other noble metals such as rhodium, iridium, palladium, silver and gold or metal alloys, or chemicals containing noble metals thereof may be applied to the component surface. Various processes may be utilized to apply the noble metal or noble metal alloys to the surfaces such as plasma spray, chemical vapor deposition, physical vapor deposition, HVOF, electroplating or electroless plating. It will be appreciated that in normal water chemistry as well as hydrogenated water chemistry, the metal oxides in the high temperature/high flow water have a negative electric potential.

The dielectric coating noted in the above-identified patent works reasonably well in water containing a certain magnitude of oxygen. However, the ceramic coating does not completely mitigate or eliminate fouling i.e., deposition of crud on the component surfaces, mainly due to unknown water chemistry conditions. The reduced oxygen content in those BWRs using hydrogenated water is beneficial in many respects including improving the longevity of the piping and reactor internals. However, deposition of crud and fouling in BWRs using hydrogenated water has remained a problem. By applying a noble metal or a noble metal alloy to the component surface, for example platinum to a thickness about of 10 µm, the resulting coating mitigates, reduces or eliminates crud deposition i.e. fouling, particularly in BWRs using reduced oxygen or hydrogenated water chemistry. It is believed that by applying a noble metal surface coating, the sign of the charge on the metal surface changes to the same one as the suspended metal or metal oxide particles in the hydrogenated water and are either less attracted to or repelled by the component surface, having the noble metal or noble metal alloy coating.

As a representative example, typical fouling material in solution may include Fe₂O₃ and Fe₃O₄, both of which develop a surface charge. The potential difference between the charge fouling material and the bulk solution is identified as the zeta potential. The zeta potential is a characteristic of the solid substrates/electrolytic solution system. The zeta potentials of the charged fouling material in the component surface must therefore be opposite in sign for fouling or deposition of crud to occur. The zeta potential of a given particle of metal oxide or hydroxide depends on the metal element, the oxidation state, the degree of oxide hydration and H+/OH-concentrations. The pH at which the surface charge disappears is called zero point of charge (ZPC). This corresponds to the isoelectric point of surface where the surface has an equal tendency to release positive and negative ions. Metal oxides in normal water chemistry have an IEPS in excess of 7 providing a positive surface charge, whereas metal oxides in the same water have an IEPS less than 7 form a negative surface charge. The surfaces of oxide particles dispersed in water tend to coordinate water molecules to form hydroxylated surfaces. The surfaces may become positively or negatively charged depending on pH. The stability of oxide particles is related to the zeta potential of the oxide particles. The zeta potential is positive at low pH and negative at high pH. Thus, by controlling the zeta potential by applying a surface coating of noble metal or alloys thereof to the component surfaces, a neutral or negative surface charge is provided. As a consequence, it will be appreciated that the coating material i.e. noble metal or noble metal alloys has the same sign or close to the same sign on the component surface as the sign of the metallic oxide particulates in the solution. Stated differently, the coating material avoids the opposite sign of the particulate charge.

Consequently, with the application of noble metal or noble metal alloys to the component surfaces, the fouling or crud deposition onto the component surfaces is mitigated or eliminated which eliminates or minimizes the need to clean the component surfaces. Moreover, the coating is durable in the high flow environment, does not delaminate and does not erode or corrode the piping. The coating is also benign to the system and cost effective.

## Claims

1. A method of reducing, minimizing or eliminating deposition of charged particulates on metal surfaces of a component subject to high temperature/high flow water, said method comprising the step of applying at least one noble metal or an alloy thereof to the surface.

2. The method as defined in claim 1 wherein said noble metal is one of platinum, rhodium, iridium, palladium, silver, gold, or metal alloys thereof.

3. The method as defined in claim 2 wherein said noble metal is platinum.

4. The method defined in claim 1 wherein said noble metal is one of chemicals containing one or more noble metals.

5. The method as defined in claim 1 wherein said noble metal is applied using a method selected from the group consisting of plasma spray, HVOF, CVD, PVD, electroplating and electroless plating.

6. The method as defined in claim 1, wherein said noble metal is deposited in an amount of about 10 µm thickness.

7. The method as defined in claim 1, wherein the particulates in the water flow have a negative charge, and including the step of providing hydrogenated water which, in conjunction with the noble metal surface, forms a same charge on the surface reducing, minimizing or eliminating the deposition of the particulate material on the surface.

8. A method according to claim 1, wherein the particulates in the water flow have a predetermined charge, and including the step of providing a zeta potential with the same predetermined charge on the surface.

9. A method of reducing, minimizing or eliminating deposition of charge particulates on interior metal wall surfaces defining a coolant flow passage in a jet pump for a nuclear reactor comprising the step of: depositing one of a noble metal or noble metal alloy on the interior metal wall surfaces of one of a nozzle (24) and a mixing section (25) forming part of an inlet mixer (23) of the jet pump (18) for disposition in the radioactive environment of the nuclear reactor to reduce, minimize or eliminate an electric potential between the metal wall surfaces and the charged particulates.

10. A method according to claim 9, including the step of providing a hydrogen water chemistry in the flow passage which, in conjunction with the noble metal or noble metal alloy surface deposition, or noble metal chemical injection, forms a charge on the surface of like sign as the sign of the charged particulates in the water flow.
